# EUROPEAN PATENT APPLICATION

(11) **EP 1 762 856 A1**
(43) Date of publication of application: **14.03.2007**
(21) Application number: 06120122.4
(22) Date of filing: 05.09.2006
(51) Int. Cl.: G01R 31/3185

(54) **Fault Diagnosis Apparatus and Method for System-on-Chip (SOC)**

(30) Priority: 10.09.2005 KR 20050084424
(71) Applicant: Samsung Electronics Co., Ltd., Suwon-si 442-742 Gyeonggi-Do (KR)
(72) Inventor: Bae, Jum-han, Seongnam-si Gyeonggi-do (KR)
(74) Representative: Brandon, Paul Laurence

(57) **Abstract**

A fault diagnosis apparatus and method which can immediately or remotely diagnose faults in a system-on-chip (SoC) (110) mounted on a product, and a system-on-chip in which faults are capable of being diagnosed. The fault diagnosis apparatus for an SoC includes an instruction input unit (100) which inputs fault diagnosis request instruction to the SoC, and an output unit (120) which receives a diagnosis result from the SoC and outputs the diagnosis result, and the SoC receives the fault diagnosis request instruction, diagnoses its own faults, and outputs the diagnosis result to the output unit, thereby immediately or remotely diagnosing faults in the SoC mounted on a product.

## Description

The present invention relates to a fault diagnosis apparatus and methods for a system-on-chip (SoC)

As semiconductor fabrication technology achieves high integration, an SoC has emerged in which various semiconductor parts, such as a processor, a memory, a peripheral, and so on, are combined onto one chip. Fault diagnosis of SoCs has, thus, become very difficult, since the number of semiconductor parts included in one chip has gradually increased to improve performance.

Accordingly, an SoC having a built-in-self-test (BIST) structure was integrated. However, the BIST structure only finds faults in the SoC before the SoC is mounted on a product. That is, the BIST structure receives various test signals considering the specification of the SoC and outputs test result signals, thereby testing for faults in the SoC. Accordingly, test equipment which can provide the test signals and analyze the test result signals is required for testing the SoC.

When a product having the SoC is out of order, it is difficult to utilize BIST testing technology because the specification of the SoC should be considered in order to diagnose the fault in the SoC mounted on the product using the aforementioned fault testing technology. However, it is actually difficult to provide test signals considering the specification of the SoC and diagnose the fault based on a test result because the specification can vary with the kind of the product. Accordingly, when the product is out of order, it is difficult to immediately or remotely diagnose the fault in the SoC mounted on the product.

Preferred embodiments of the present invention aim to provide a fault diagnosis apparatus and method which can immediately or remotely diagnose faults in a system-on-chip (SoC) mounted on a product.

Preferred embodiments of the present invention also aim to provide a fault diagnosis apparatus and method which can remotely diagnose faults in a system-on-chip (SoC) mounted on a product through a network.

Preferred embodiments of the present invention also aim to provide a system-on-chip which is mounted on a product and in which faults are capable of being diagnosed when fault diagnosis is requested.

Additional features of the invention will be set forth in part in the description which follows and, in part, will be obvious from the description, or may be learned by practice of the invention.

According to an aspect of the present invention, there is provided a fault diagnosis apparatus for a system-on-chip (SoC), the apparatus including: an instruction input unit which inputs a fault diagnosis request instruction to the SoC; and an output unit which receives a diagnosis result from the SoC and outputs the diagnosis result, wherein the SoC receives the fault diagnosis request instruction, diagnoses its own faults, and outputs the diagnosis result to the output unit.

According to another aspect of the present invention, there is provided a fault diagnosis apparatus for a system-on-chip (SoC), including: a transmission/reception unit which receives a fault diagnosis request instruction of the SoC through a network to send the fault diagnosis request instruction to the SoC, and receives a diagnosis result from the SoC to transmit the diagnosis result to the network, wherein the SoC receives the fault diagnosis request instruction, diagnoses its own faults, and provides the diagnosis result to the transmission/reception unit.

According to another aspect of the present invention, there is provided a fault diagnosis method for a system-on-chip (SoC) mounted on a product, including: sending the fault diagnosis request instruction to the SoC if a fault diagnosis request instruction of the SoC is applied; applying a pseudo random pattern to a plurality of scan chains included in the SoC during a fault diagnosis period of the SoC; obtaining values output from the plurality of scan chains during the fault diagnosis period; diagnosing faults in the plurality of scan chains by comparing the values obtained from the plurality of scan chains with expected values and outputting a diagnosis result from the SoC; and outputting the diagnosis result output from the SoC to the outside of the product.

According to yet another aspect of the present invention, there is provided a system-on-chip (SoC) in which faults are capable of being diagnosed, including: a pseudo random pattern generator which generates a pseudo random pattern to be applied to a plurality of scan chains in the SoC during a fault diagnosis period of the SoC; and a diagnosis processor which receives a fault diagnosis request instruction of the SoC, enables the pseudo random pattern generator, monitors values output from the plurality of scan chains, diagnoses faults in the plurality of scan chains, and outputs the diagnosis result.
Further features of the present invention are set out in the amended claims

The invention will become apparent and more readily appreciated from the following description of the embodiments, taken in conjunction with the accompanying drawings of which:

FIG. 1 is a functional block diagram of a fault diagnosis apparatus for a system-on-chip (SoC) according to an embodiment of the present invention;
FIG. 2 is a timing diagram of components of the SoC shown in Fig. 1;
FIG. 3 is a functional block diagram of a fault diagnosis apparatus for an SoC according to another embodiment of the present invention;
FIG. 4 is a flowchart illustrating the operation of the fault diagnosis apparatus shown in FIG. 3;
FIG. 5 is another functional block diagram of the SoC shown in FIG. 1 or FIG. 3;
FIG. 6 is a timing diagram of a BIST logic circuit shown in FIG. 5;
FIG. 7 is another functional block diagram of the SoC shown in FIG. 1 or FIG. 3;
FIG. 8 is a flowchart illustrating a fault diagnosis method for an SoC according to another embodiment of the present invention;
FIG. 9 is a flowchart illustrating a fault diagnosis method for an SoC according to another embodiment of the present invention.

Reference will now be made in detail to the present embodiments of the present invention, examples of which are illustrated in the accompanying drawings, wherein like reference numerals refer to the like elements throughout. The embodiments are described below in order to explain the present invention by referring to the figures.

Hereinafter, exemplary embodiments of the present invention will be described with reference to the accompanying drawings.

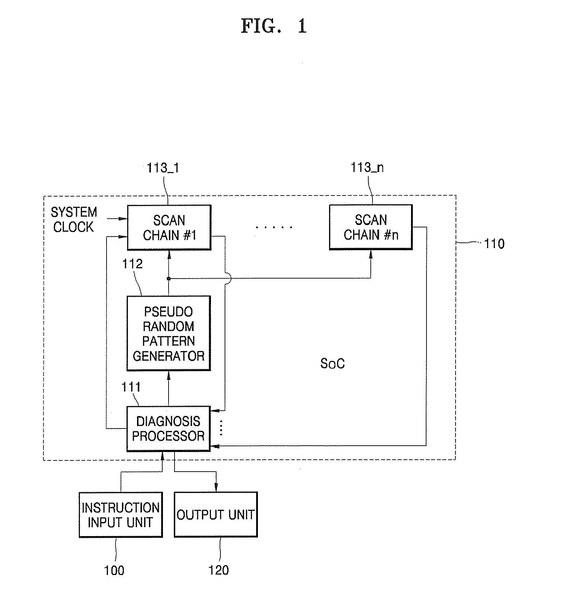

FIG. 1 is a functional block diagram of a fault diagnosis apparatus for a system-on-chip (SoC) according to an embodiment of the present invention, and illustrates an example of directly diagnosing a fault in the SoC mounted on a product.

Referring to FIG. 1, the apparatus includes an instruction input unit 100, an SoC 110, and an output unit 120.

The instruction input unit 100 inputs a fault diagnosis request instruction to the SoC 110. The instruction input unit 100 may include a fault diagnosis request button.

The SoC 110 receives the fault diagnosis request instruction from the instruction input unit 100, diagnoses its own faults, and outputs a diagnosis result. The SoC 110 includes a diagnosis processor 111, a pseudo random pattern generator 112, and scan chains #1 to #n 113_1 to 113_n.

The diagnosis processor 111 receives the fault diagnosis request instruction, enables the pseudo random pattern generator 112, monitors values output from the scan chains #1 to #n 113_1 to 113_n during a fault diagnosis period, diagnoses any faults in the scan chains #1 to #n 113_1 to 113_n, and outputs the diagnosis result.

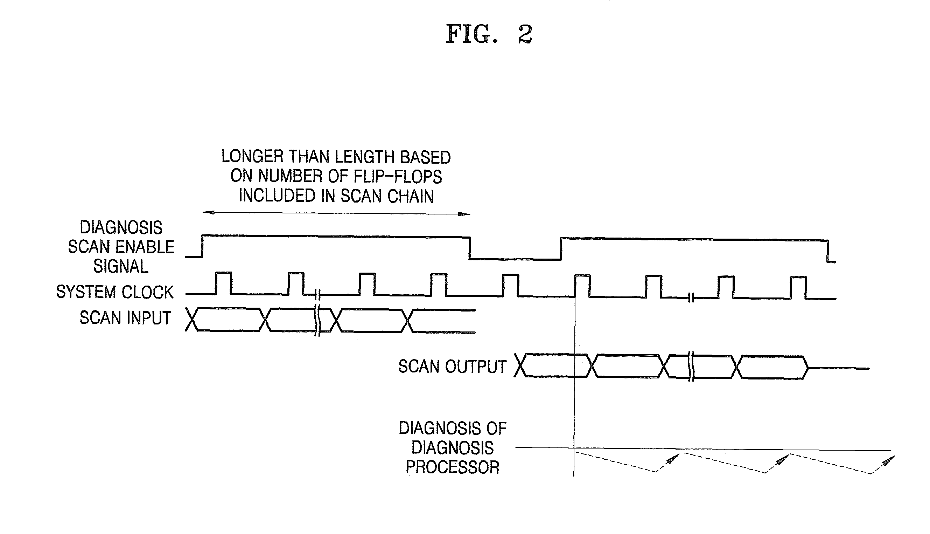

The diagnosis processor 111 enables the scan chains #1 to #n 113_1 to 113_n using a diagnosis scan enable signal having a period shown in FIG. 2. The diagnosis processor 111 also enables the pseudo random pattern generator 112 during the fault diagnosis period using a pseudo random pattern enable signal. FIG. 2 is a timing diagram of the diagnosis processor 111, the pseudo random pattern generator 112, and the scan chains #1 to #n 113_1 to 113_n of the SoC 110 shown in Fig. 1. As can be seen from FIG. 2, the length of an active period of the diagnosis scan enable signal is longer than the length based on the number of flip-flops included in the scan chains #1 to #n 113_1 to 113_n.

The diagnosis processor 111 inputs pseudo random pattern data to the scan chains #1 to #n 113_1 to 113_n in a first active period of the diagnosis scan enable signal, obtains values output from the scan chains #1 to #n 113_1 to 113_n at constant intervals in the next active period of the diagnosis scan enable signal, and diagnoses faults by comparing the obtained values with expected values.

If the obtained values are all identical to the expected values, then the diagnosis processor 111 determines that the scan chains #1 to #n 113_1 to 113_n are all in a normal state. If at least one of the obtained values is different from the expected value, then the diagnosis processor 111 determines that at least one of the scan chains #1 to #n 113_1 to 113_n is out of order. The expected values are based on the specification of the scan chains #1 to #n 113_1 to 113_n defined in the SoC 110 and a pseudo random pattern. During the fault diagnosis period, faults can be diagnosed by inputting a scan input to the scan chains #1 to #n 113_1 to 113_n and obtaining a scan output.

The pseudo random pattern generator 112 generates the pseudo random pattern which will be applied to the scan chains #1 to #n 113_1 to 113_n in the SoC 110 during the fault diagnosis period. The fault diagnosis period is controlled by the pseudo random pattern enable signal provided by the diagnosis processor 111.

The scan chains #1 to #n 113_1 to 113_n can comprise a predetermined number of flip-flops, for example, 1000 or 2000 flip-flops. The scan chains #1 to #n 113_1 to 113_n may output the results of shifting the input pseudo random pattern (scan input of FIG. 2) by the number of flip-flops connected to the scan chains in synchronization with a system clock (see a system clock of FIG. 2) and loading the shifted pseudo random pattern, momentarily switching a test mode to a normal mode and capturing the data loaded in the scan chains #1 to #n 113_1 to 113_n, and shifting and loading the captured results. The outputs (scan output of FIG. 2) of the scan chains #1 to #n 113_1 to 113_n are transmitted to the diagnosis processor 111.

The output unit 120 outputs the diagnosis result received from the diagnosis processor 111. The output unit 120 may include a sound output unit or a display unit to output the diagnosis result from the diagnosis processor 111, but is not limited thereto. An operator of the product or the fault diagnosis apparatus shown in FIG. 1 can directly determine the fault in the SoC 110.

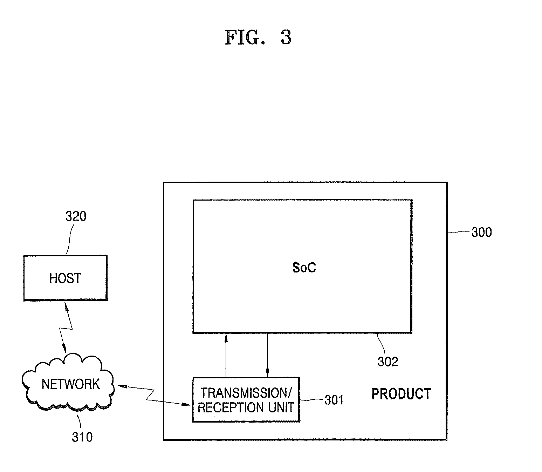

FIG. 3 is a functional block diagram of a fault diagnosis apparatus for an SoC according to another embodiment of the present invention, and illustrates an example of remotely diagnosing a fault in an SoC 302 mounted on a product. Referring to FIG. 3, the apparatus includes the product 300 having the SoC 302, a network 310, and a host 320.

The product 300 is an electronic product that may be used in a home or office, but not limited thereto, and includes a transmission/reception unit 301 and the SoC 302. The transmission/reception unit 301 receives a fault diagnosis request instruction through the network 310 and sends the fault diagnosis request instruction to the SoC 302. The transmission/reception unit 301 receives a diagnosis result from the SoC 302 and transmits the diagnosis result to the network 310. The transmission/reception unit 301 may be a modem connected to an Ethernet network or the internet.

The SoC 302 has the same construction as the SoC 110 shown in FIG. 1. Accordingly, the SoC 302 receives the fault diagnosis request instruction from the transmission/reception unit 301, diagnoses its own faults, and provides the diagnosis result to the transmission/reception unit 301.

The network 310 may be an Ethernet network or the internet, but is not limited thereto.

A host 320 is a computer system which monitors the performance of the product 300 in a remote place and is operated by an operator. If the product 300 is out of order, to determine whether the fault is in the SoC 302 mounted on the product 300, the host 320 can transmit the fault diagnosis request instruction through the network 310, receive the diagnosis result through the network 310, and output the diagnosis result to the operator.

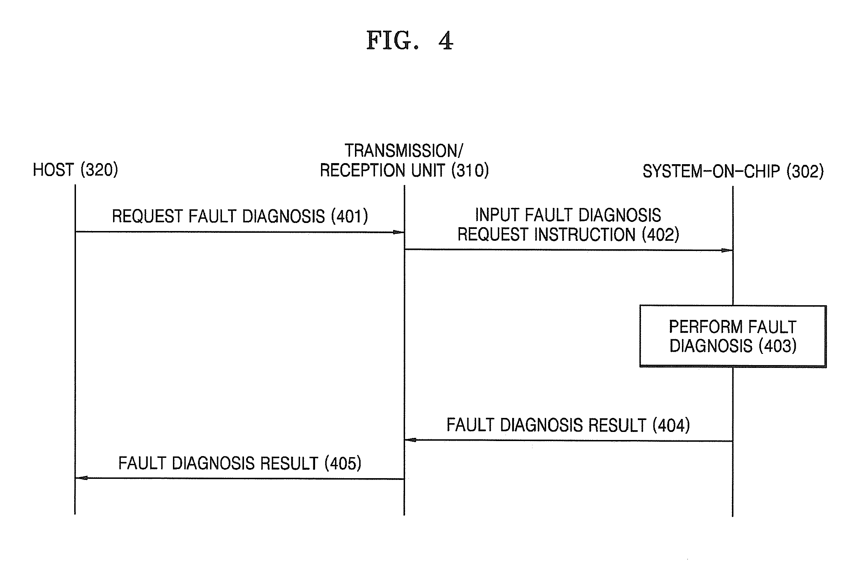

FIG. 4 is a flowchart illustrating the operation of the fault diagnosis apparatus shown in FIG. 3. If the fault diagnosis is requested by the host 320 (401), the transmission/reception unit 301 sends the fault diagnosis request instruction to the SoC 302 (402). The SoC 302 diagnoses its own fault (403). When the diagnosis result is output from the SoC 302 (404), the transmission/reception unit 301 transmits the diagnosis result to the host 320 (405). The operator of the host 320 can remotely determine whether the SoC 302 mounted on the product 300 is out of order based on the diagnosis result.

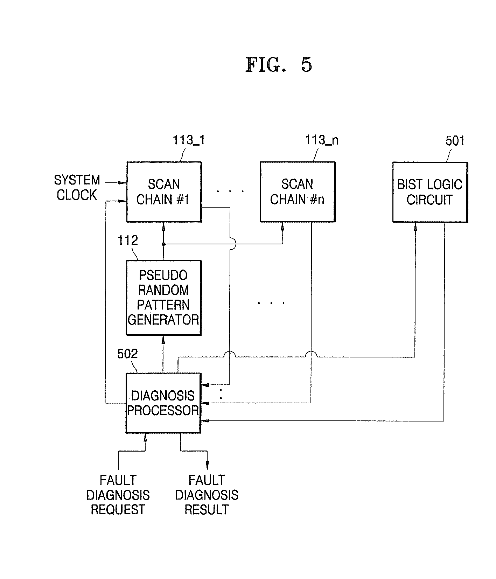

FIG. 5 is another functional block diagram of the SoCs 110 and 302 shown in FIG. 1 and FIG. 3. While the SoCs 110 and 302 of FIG. 1 and FIG. 3 include the scan chains #1 to #n 113_1 to 113_n, the SoC of FIG. 5 includes a built-in-self-test (BIST) logic circuit 501 in addition to the scan chains #1 to #n 113_1 to 113_n.

The BIST logic circuit 501 can test its own performance. When a control signal (for example, BCLK) including an ON signal BISTON is received, the BIST logic circuit 501 outputs a test result signal ERRORB together with a signal DONE which indicates test completion. The BIST logic circuit 501 may be generally called a memory BIST.

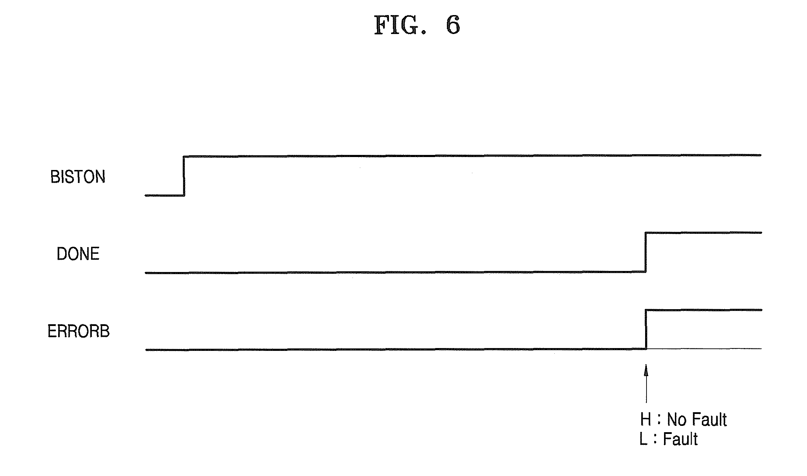

FIG. 6 is a timing diagram of the BIST logic circuit 501 shown in FIG. 5. Referring to FIG. 6, when the ON signal BISTON having a high level is applied, the BIST logic circuit 501 tests its own logic circuit. When the test is completed, the BIST logic circuit 501 outputs the signal DONE, having a high level, and the test signal ERRORB (ERRORBar). If the test signal ERRORB is at a high level, the diagnosis processor 502 determines that the BIST logic circuit 501 is in a normal state. If the test result signal ERRORB is at a low level, the diagnosis processor 502 determines that the BIST logic circuit 501 is out of order.

The diagnosis processor 502 has a function for diagnosing the BIST logic circuit 501 in addition to the function of the diagnosis processor 111 shown in FIG. 1. Accordingly, the diagnosis processor 502 receives the fault diagnosis request instruction, provides the control signal including the ON signal BISTON to the BIST logic circuit 501, diagnoses faults in the BIST logic circuit 501 based on the test result signal provided from the BIST logic circuit 501, and outputs the diagnosis result.

The operations of the pseudo random pattern generator 112, the scan chains #1 to #n 113_1 to 113_n, and the diagnosis processor 502 during the fault diagnosis period are the same as those described with reference to FIG. 1.

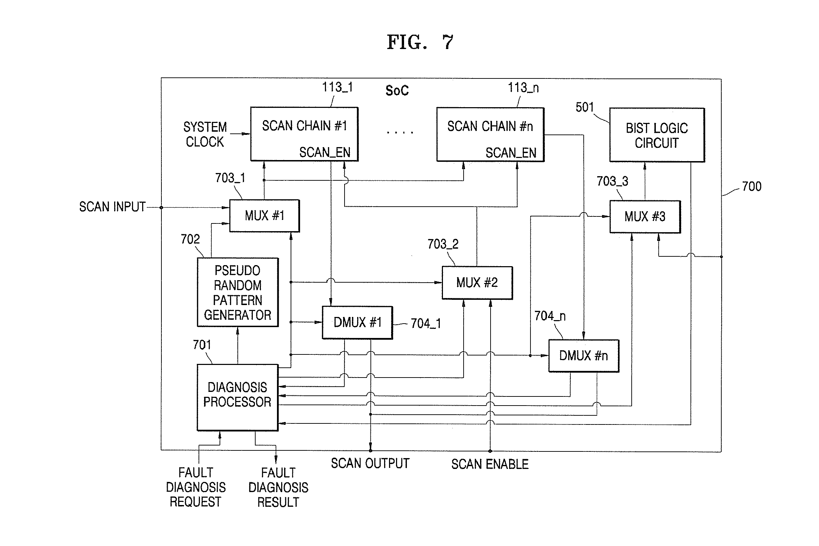

FIG. 7 is another functional block diagram of the SoCs shown in FIG. 1 and FIG. 3. The SoC of FIG. 7 includes switches for switching inputs and outputs of the scan chains #1 to #n 113_1 to 113_n and the BIST logic circuit 501 during the fault diagnosis period and a fault non-diagnosis period, in addition to the scan chains #1 to #n 113_1 to 113_n and the BIST logic circuit 501 of FIG. 5.

The switches include multiplexers MUX #1 703_1, MUX #2 703_2, and MUX #3 703_3 and demultiplexers DMUX #1 to #n 704_1 to 704_n.

The multiplexer MUX #1 703_1 sends a pseudo random pattern output from a pseudo random pattern generator 702 to the scan chains #1 to #n 113_1 to 113_n during the fault diagnosis period, and transmits a scan input signal input from the outside of the SoC 700 to the scan chains #1 to #n 113_1 to 113_n during the fault non-diagnosis period, under the control of a diagnosis processor 701.

The multiplexer MUX #2 703_2 sends a diagnosis scan enable signal output from the diagnosis processor 701 to the scan chains #1 to #n 113_1 to 113_n during the fault diagnosis period, and transmits a scan enable signal input from the outside of the SoC 700 to the scan chains #1 to #n 113_1 to 113_n during the fault non-diagnosis period, under the control of a diagnosis processor 701.

The multiplexer MUX #3 703_3 sends a control signal output from the diagnosis processor 701 to the BIST logic circuit 501 during the fault diagnosis period, and transmits the control signal input from the outside of the SoC 700 to the BIST logic circuit 501 during the fault non-diagnosis period, under the control of a diagnosis processor 701.

The demultiplexers DMUX #1 to #n 704_1 to 704_n transmit the signals output from the scan chains #1 to #n 113_1 to 113_n to the diagnosis processor 701 during the fault diagnosis, and output the signals output from the scan chains #1 to #n 113_1 to 113_n to the outside of the SoC 700 as a scan output during the fault non-diagnosis period.

The multiplexer #1 703_1 is a first switch, the multiplexer #2 703_2 is a second switch, the multiplexer #3 703_3 is a third switch, and the demultiplexers DMUX #1 to #n 704_1 to 704_n are a group of fourth switches.

The diagnosis processor 701 includes a function to control the multiplexers MUX #1 703_1, MUX #2 703_2, and MUX #3 703_3 and demultiplexers DMUX #1 to #n 704_1 to 704_n, in addition to functions to enable the pseudo random pattern generator 702, to diagnose the scan chains #1 to #n 113_1 to 113_n, and to diagnose the BIST logic circuit 501, which are described with reference to FIGs. 1 and 5. The pseudo random pattern generator 702 is the same as the pseudo random pattern generator 112 shown in FIG. 1.

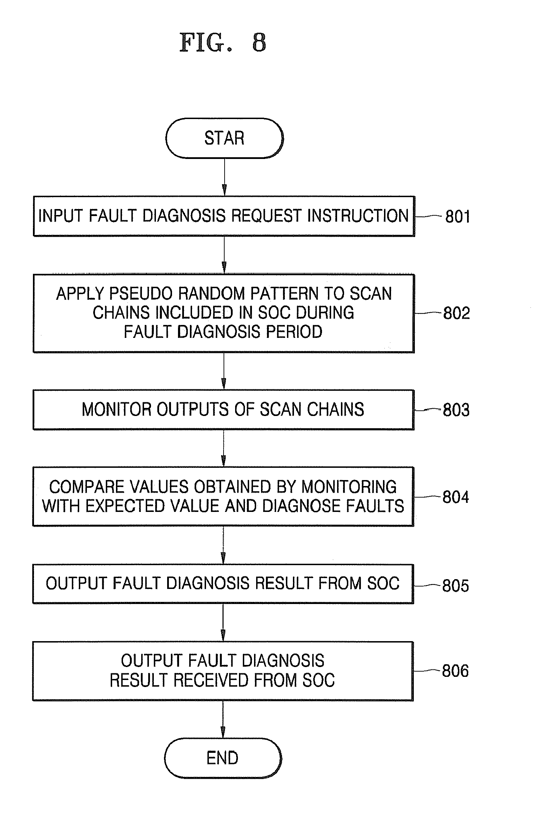

FIG. 8 is a flowchart illustrating a fault diagnosis method for an SoC according to another embodiment of the present invention, and illustrates the case of immediately diagnosing the SoC mounted on the product, like the fault diagnosis apparatus shown in FIG. 1. Accordingly, the operations of FIG. 8 will be described with reference to FIGs. 1 and 8.

If the fault diagnosis request instruction is applied using the instruction input unit 100 included in the product having the SoC 110, the fault diagnosis request instruction is input to the SoC 110 (801). The diagnosis processor 111 included in the SoC 110 controls the pseudo random pattern generator 112 such that the pseudo random pattern is applied to the scan chains #1 to #n 113_1 to 113_n included in the SoC 110 during the fault diagnosis period (802).

During the fault diagnosis period, the diagnosis processor 111 obtains values output from the scan chains #1 to #n 113_1 to 113_n (803), diagnoses faults in the scan chains #1 to #n 113_1 to 113_n by comparing the obtained values with expected values (804), and outputs the diagnosis result from the SoC 110 (805). The diagnosis is performed as described for the diagnosis processor 111 with reference to FIG. 1.

The output unit 120 included in the product outputs the diagnosis result received from the SoC 110 so that a user or an operator can determine whether the SoC 110 is out of order (806).

Here, the flowchart of FIG. 8 can apply to the case of remotely diagnosing the fault in the SoC mounted on the product, like the fault diagnosis apparatus shown with reference to FIG. 3. If the flowchart of FIG. 8 applies to the case of remotely diagnosing the fault in the SoC mounted on the product, in operation 801, the fault diagnosis request instruction is input to the SoC 302 when the fault diagnosis request of the SoC 302 is received through the network 301. Furthermore, in operation 803, the diagnosis result output from the SoC 302 is transmitted to the host 320 through the network 310.

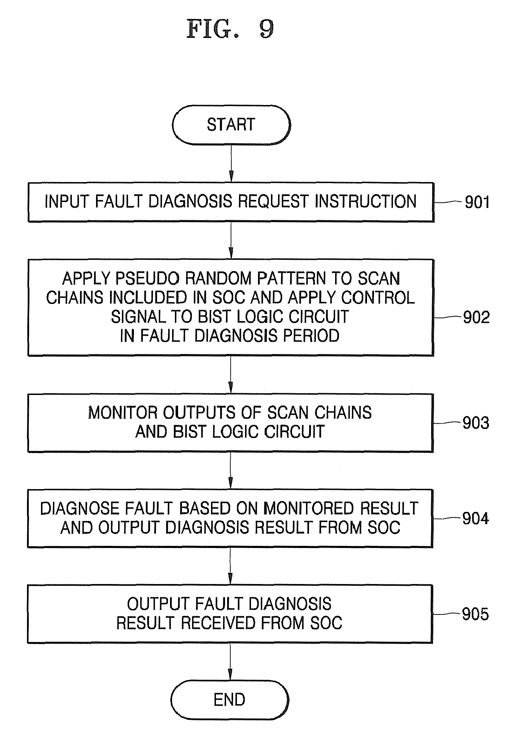

FIG. 9 is a flowchart illustrating a fault diagnosis method for an SoC according to another embodiment of the present invention. While FIG. 8 illustrates the fault diagnosis method of the SoC having a plurality of scan chains, FIG. 9 illustrates the fault diagnosis method of the SoC having a plurality of scan chains and a BIST circuit.

Accordingly, the operations 901 through 905 of FIG. 9 are similar to the operations 801 through 806 described with reference to FIG. 8.

In operation 902, the SoC mounted on the product applies the pseudo random pattern to the scan chains #1 to #n 113_1 to 113_n included in the SoC during the fault diagnosis period and applies the control signal to the BIST logic circuit. The control signal of the BIST logic circuit is the same as that described with reference to FIG. 5.

In operation 903, the SoC monitors the outputs of the scan chains #1 to #n 113_1 to 113_n and the output of the BIST logic circuit.

In operation 904, the SoC diagnoses any faults in the scan chains #1 to #n 113_1 to 113_n and the BIST logic circuit based on the monitoring result and outputs the diagnosis result. At this time, fault diagnosis is performed similar to the fault diagnosis of the diagnosis processor 502 described with reference to FIG. 5. In operation 905, the fault diagnosis result received from the SoC is output to the product's outside.

The invention can also be embodied as computer readable code on a computer readable recording medium. The computer readable recording medium is any data storage device that can store data which can be thereafter read by a computer system. Examples of the computer readable recording medium include read-only memory (ROM), random-access memory (RAM), CD-ROMs, magnetic tapes, floppy disks, optical data storage devices, and computer data signals embodied in carrier wave (such as data transmission through the internet). The computer readable recording medium can also be distributed over network coupled computer systems so that the computer readable code is stored and executed in a distributed fashion.

As described above, according to preferred embodiments of the present invention, if fault diagnosis is immediately or remotely requested of an SoC mounted on a product, the SoC diagnoses its own faults and outputs a diagnosis result. Accordingly, based on the diagnosis result output from the SoC, it can be determined whether the SoC is out of order. In the case where the product is out of order due to a fault in the SoC, the fault cause can be easily found and treated.

While the present invention has been particularly shown and described with reference to exemplary embodiments thereof, it will be understood by those of ordinary skill in the art that various changes in form and detail may be made therein without departing from the spirit and scope of the present invention as defined by the following claims.

Although a few embodiments of the present invention have been shown and described, it would be appreciated by those skilled in the art that changes may be made in this embodiment without departing from the principles and spirit of the invention, the scope of which is defined in the claims and their equivalents.
Attention is directed to all papers and documents which are filed concurrently with or previous to this specification in connection with this application and which are open to public inspection with this specification, and the contents of all such papers and documents are incorporated herein by reference.
All of the features disclosed in this specification (including any accompanying claims, abstract and drawings), and/or all of the steps of any method or process so disclosed, may be combined in any combination, except combinations where at least some of such features and/or steps are mutually exclusive.
Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.
The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A fault diagnosis apparatus for a system-on-chip (SoC) (110), the apparatus comprising:
an instruction input unit (100) which inputs a fault diagnosis request instruction to the SoC; and
an output unit (120) which receives a diagnosis result from the SoC and outputs the diagnosis result,
wherein the SoC receives the fault diagnosis request instruction, diagnoses its own faults, and outputs the diagnosis result to the output unit.

2. The fault diagnosis apparatus as claimed in claim 1, wherein the SoC (110) comprises:
a plurality of scan chains (113_l, 11_n) which outputs values of results of a pseudo random pattern input therein;
a pseudo random pattern generator (112, 702) which generates the pseudo random pattern to be applied to the plurality of scan chains in the SoC during a fault diagnosis period; and
a diagnosis processor (111, 502, 701) which receives the fault diagnosis request instruction, enables the pseudo random pattern generator, monitors the values output from the plurality of scan chains, diagnoses faults in the plurality of scan chains, and outputs the diagnosis result.

3. The fault diagnosis apparatus as claimed in claim 2, wherein the plurality of scan chains (113_1, 113_n) comprises a predetermined number of flip-flops, and outputs the values of the results of shifting the pseudo random pattern input therein by the predetermined number of the flip-flops in synchronization with a system clock.

4. The fault diagnosis apparatus as claimed in claim 2 or claim 3, wherein:
the diagnosis processor (111, 502, 701) enables the pseudo random pattern generator (112, 702) by transmitting a pseudo random pattern enable signal to the pseudo random pattern generator; and
the diagnosis processor enables the plurality of scan chains by transmitting a diagnosis scan enable signal to the plurality of scan chains (113_1, 113_n).

5. The fault diagnosis apparatus as claimed in claim 2, wherein the diagnosis processor (111, 502, 701) obtains the values output from the plurality of scan chains (113_1, 113_n) at constant intervals during the fault diagnosis period and diagnoses faults by comparing the obtained values with expected values.

6. The fault diagnosis apparatus as claimed in any one claim 2 - 5, wherein the SoC (110) further comprises a built-in-self-test (BIST) logic circuit (501),
wherein the diagnosis processor (111, 502), 701) receives the fault diagnosis request instruction, provides a control signal to the BIST logic circuit, diagnoses faults in the BIST logic circuit based on a test result signal provided from the BIST logic circuit, and outputs the diagnosis result.

7. The fault diagnosis apparatus as claimed in claim 1, wherein the SoC (110) further comprises:
a built-in-self-test (BIST) logic circuit (501); and
a diagnosis processor (111, 502, 701) which receives the fault diagnosis request instruction, provides a control signal to the BIST logic circuit, diagnoses faults in the BIST logic circuit based on a test result signal provided from the BIST logic circuit, and outputs the diagnosis result.

8. The fault diagnosis apparatus as claimed in claim 6, wherein the SoC (110) further comprises:
a first switch (703-1) which sends the pseudo random pattern to the plurality of scan chains during the fault diagnosis period and transmits a scan input signal input from an outside of the SoC to the plurality of scan chains during a fault non-diagnosis period, under the control of the diagnosis processor (111, 701);
a second switch (703-2) which sends a diagnosis scan enable signal output from the diagnosis processor to the plurality of scan chains during the fault diagnosis period and transmits a scan enable signal input from the outside of the SoC to the plurality of scan chains during the fault non-diagnosis period, under the control of the diagnosis processor;
a third switch (703-3) which transmits a control signal output from the diagnosis processor to the BIST logic circuit (701) during the fault diagnosis period and transmits the control signal applied from the outside of the SoC to the BIST logic circuit during the fault non-diagnosis period, under the control of the diagnosis processor; and
a group of fourth switches (704_l, 704_n) which transmits signals output from the plurality of scan chains to the diagnosis processor during the fault diagnosis period and outputs the signals output from the plurality of scan chains to the outside of the SoC during the fault non-diagnosis period,
wherein the group of fourth switches is provided in correspondence with the plurality of scan chains, respectively.

9. The fault diagnosis apparatus as claimed in claim 8, wherein the first switch (703_1) comprises a multiplexer, the second switch (703_2) comprises a multiplexer, the third switch (703_3) comprises a multiplexer, and the group of fourth switches (704_1, 704_n) comprises a group of demultiplexers.

10. The fault diagnosis apparatus as claimed in claim 2, wherein the SoC further comprises:
a first switch (703_1) which sends the pseudo random pattern to the plurality of scan chains (113_1, 113_n) during the fault diagnosis period and transmits a scan input signal input from an outside of the SoC to the plurality of scan chains during a fault non-diagnosis period, under the control of the diagnosis processor (701);
a second switch (703_2) which sends a diagnosis scan enable signal output from the diagnosis processor to the plurality of scan chains during the fault diagnosis period and transmits a scan enable signal input from the outside of the SoC to the plurality of scan chains during the fault non-diagnosis period, under the control of the diagnosis processor; and
a group of third switches (704_1, 704_n) which transmits signals output from the plurality of scan chains to the diagnosis processor during the fault diagnosis period and outputs the signals output from the plurality of scan chains to the outside of the SoC during the fault non-diagnosis period,
wherein the group of third switches is provided in correspondence with the plurality of scan chains, respectively.

11. The fault diagnosis apparatus as claimed in claim 10, wherein the first switch (703_1) comprises a multiplexer, the second switch (703_2) comprises a multiplexer, and the group of third switches (704_1, 704_n) comprises a group of demultiplexers.

12. A fault diagnosis apparatus for a system-on-chip (SoC) (110), the apparatus comprising:
a transmission/reception unit (301) which receives a fault diagnosis request instruction of the SoC through a network (310), sends the fault diagnosis request instruction to the SoC, receives a diagnosis result from the SoC, and transmits the diagnosis result to the network,
wherein the SoC receives the fault diagnosis request instruction, diagnoses its own faults, and provides the diagnosis result to the transmission/reception unit.

13. The fault diagnosis apparatus as claimed in claim 12, wherein the SoC (110) comprises:
a plurality of scan chains (113_l, 113_n) which outputs values of results of a pseudo random pattern input therein;
a pseudo random pattern generator (112) which generates the pseudo random pattern to be applied to the plurality of scan chains in the SoC during a fault diagnosis period of the SoC; and
a diagnosis processor (111, 502, 701) which receives the fault diagnosis request instruction, enables the pseudo random pattern generator, monitors the values output from the plurality of scan chains, diagnoses faults in the plurality of scan chains, and outputs the diagnosis result.

14. The fault diagnosis apparatus as claimed in claim 13, wherein the plurality of scan chains (113_l, 113_n) comprises a predetermined number of flip-flops, and outputs the values of the results of shifting the pseudo random pattern input therein by the predetermined number of the flip-flops in synchronization with a system clock.

15. The fault diagnosis apparatus as claimed in claim 13 or claim 14, wherein:
the diagnosis processor (111, 502, 701) enables the pseudo random pattern generator (112) by transmitting a pseudo random pattern enable signal to the pseudo random pattern generator; and
the diagnosis processor enables the plurality of scan chains (113_l, 113_n) by transmitting a diagnosis scan enable signal to the plurality of scan chains.

16. The fault diagnosis apparatus as claimed in any one of claims 13 - 15, wherein the diagnosis processor (111,502, 701) obtains the values output from the plurality of scan chains (113_l, 113_n) at constant intervals during the fault diagnosis period and diagnoses faults by comparing the obtained values with expected values.

17. The fault diagnosis apparatus as claimed in any one of claims 13 - 16, wherein the SoC (110) further comprises a built-in-self-test (BIST) logic circuit,
wherein the diagnosis processor (111, 502, 701) receives the fault diagnosis request instruction, provides a control signal to the BIST logic circuit, diagnoses faults in the BIST logic circuit based on a test result signal provided from the BIST logic circuit, and outputs the diagnosis result.

18. The fault diagnosis apparatus as claimed in claim 12, wherein the SoC (110) further comprises:
a built-in-self-test (BIST) logic circuit (501); and
a diagnosis processor (111, 502, 701) which receives the fault diagnosis request instruction, provides a control signal to the BIST logic circuit, diagnoses faults in the BIST logic circuit based on a test result signal provided from the BIST logic circuit, and outputs the diagnosis result.

19. The fault diagnosis apparatus as claimed in claim 17, wherein the SoC (110) further comprises:
a first switch (703_1) which sends the pseudo random pattern to the plurality of scan chains (113_l, 113_n) during the fault diagnosis period and transmits a scan input signal input from an outside of the SoC to the plurality of scan chains during a fault non-diagnosis period, under the control of the diagnosis processor (111, 701);
a second switch (703_2) which sends a diagnosis scan enable signal output from the diagnosis processor to the plurality of scan chains during the fault diagnosis period and transmits a scan enable signal input from the outside of the SoC to the plurality of scan chains during the fault non-diagnosis period, under the control of the diagnosis processor;
a third switch (703_3) which transmits a control signal output from the diagnosis processor to the BIST logic circuit (501) during the fault diagnosis period and transmits the control signal applied from the outside of the SoC to the BIST logic circuit during the fault non-diagnosis period, under the control of the diagnosis processor; and
a group of fourth switches (704_l, 704_n) which transmits signals output from the plurality of scan chains to the diagnosis processor during the fault diagnosis period and outputs the signals output from the plurality of scan chains to the outside of the SoC during the fault non-diagnosis period,
wherein the group of fourth switches is provided in correspondence with the plurality of scan chains, respectively.

20. The fault diagnosis apparatus as claimed in claim 19, wherein the first switch (703_1) comprises a multiplexer, the second switch (703_2) comprises a multiplexer, the third switch (703_3) comprises a multiplexer, and the group of fourth switches (704_l, 704_n) comprises a group of demultiplexers.

21. The fault diagnosis apparatus as claimed in claim 13, wherein the SoC (110) further comprises:
a first switch (703_1) which sends the pseudo random pattern to the plurality of scan chains (113_l, 113_n) during the fault diagnosis period and transmits a scan input signal input from an outside of the SoC to the plurality of scan chains during a fault non-diagnosis period, under the control of the diagnosis processor;
a second switch (703_2) which sends a diagnosis scan enable signal output from the diagnosis processor to the plurality of scan chains during the fault diagnosis period and transmits a scan enable signal input from the outside of the SoC to the plurality of scan chains during the fault non-diagnosis period, under the control of the diagnosis processor; and
a group of third switches (704_1, 704_n) which transmits signals output from the plurality of scan chains to the diagnosis processor during the fault diagnosis period and outputs the signals output from the plurality of scan chains to the outside of the SoC during the fault non-diagnosis period,
wherein the group of third switches is provided in correspondence with the plurality of scan chains, respectively.

22. The fault diagnosis apparatus as claimed in claim 21, wherein the first switch (703_1) comprises a multiplexer, the second switch (703_2) comprises a multiplexer, and the group of third switches (704_1, 704_n) comprises a group of demultiplexers.

23. A fault diagnosis method for a system-on-chip (SoC) (110) mounted on a product, the method comprising:
sending a fault diagnosis request instruction to the SoC if a fault diagnosis request instruction of the SoC is applied;
applying a pseudo random pattern to a plurality of scan chains included in the SoC during a fault diagnosis period of the SoC;
obtaining values output from the plurality of scan chains during the fault diagnosis period;
diagnosing faults in the plurality of scan chains by comparing the values obtained from the plurality of scan chains with expected values, and outputting a diagnosis result from the SoC to the product; and
outputting the diagnosis result from the product to an outside of the product.

24. The fault diagnosis method as claimed in claim 23, wherein the sending of the fault diagnosis request instruction comprises receiving the fault diagnosis request instruction of the SoC (110) through a network (310) and sending the fault diagnosis request instruction to the SoC,
wherein the outputting of the diagnosis result comprises transmitting the diagnosis result output from the SoC through the network.

25. The fault diagnosis method as claimed in claim 23 or claim 24, further comprising:
applying a control signal to a built-in-self-test (BIST) logic circuit (501) after the sending of the fault diagnosis request instruction to the SoC(110);
obtaining a test result signal output from the BIST logic circuit;
diagnosing faults in the BIST logic circuit and outputting an other diagnosis result from the SoC to the product; and
outputting the other diagnosis result from the product to the outside of the product.

26. A system-on-chip (SoC) (110) in which faults are capable of being diagnosed, the SoC comprising:
a plurality of scan chains (113_l, 113_n) which outputs values of results of a pseudo random pattern input therein;
a pseudo random pattern generator (112) which generates the pseudo random pattern to be applied to the plurality of scan chains in the SoC during a fault diagnosis period of the SoC; and
a diagnosis processor (111, 502, 701) which receives a fault diagnosis request instruction of the SoC, enables the pseudo random pattern generator, monitors the values output from the plurality of scan chains, diagnoses faults in the plurality of scan chains, and outputs the diagnosis result.

27. The SoC (110) as claimed in claim 26, wherein the plurality of scan chains (113_l, 113_n) comprises a predetermined number of flip-flops, and outputs the values of the results of shifting the pseudo random pattern input therein by the predetermined number of the flip-flops in synchronization with a system clock.

28. The SoC (110) as claimed in claim 26 or claim 27, wherein:
the diagnosis processor (111, 502, 701) enables the pseudo random pattern generator (112) by transmitting a pseudo random pattern enable signal to the pseudo random pattern generator; and
the diagnosis processor enables the plurality of scan chains (113_l, 113_n) by transmitting a diagnosis scan enable signal to the plurality of scan chains.

29. The SoC (110) as claimed in any one of claims 26 - 28, wherein the diagnosis processor (111, 502, 701) obtains the values output from the plurality of scan chains (113_l, 113_n) at constant intervals during the fault diagnosis period and diagnoses faults by comparing the obtained values with expected values.

30. The SoC (110) as claimed in any one of claims 26 - 29, wherein the SoC further comprises a built-in-self-test (BIST) logic circuit (501),
wherein the diagnosis processor (111, 502, 701) receives the fault diagnosis request instruction, provides a control signal to the BIST logic circuit, diagnoses faults in the BIST logic circuit based on a test result signal provided from the BIST logic circuit, and outputs the diagnosis result.

31. The SoC (110) as claimed in claim 30, further comprising:
a first switch (703_1) which sends the pseudo random pattern to the plurality of scan chains (113_l, 113_n) during the fault diagnosis period and transmits a scan input signal input from an outside of the SoC to the plurality of scan chains during a fault non-diagnosis period, under the control of the diagnosis processor (111, 701);
a second switch (703_2) which sends a diagnosis scan enable signal output from the diagnosis processor to the plurality of scan chains during the fault diagnosis period and transmits a scan enable signal input from the outside of the SoC to the plurality of scan chains during the fault non-diagnosis period, under the control of the diagnosis processor;
a third switch (703_3) which transmits a control signal output from the diagnosis processor to the BIST logic circuit (501) during the fault diagnosis period and transmits the control signal applied from the outside of the SoC to the BIST logic circuit during the fault non-diagnosis period, under the control of the diagnosis processor; and
a group of fourth switches (704_l, 704_n) which transmits signals output from the plurality of scan chains to the diagnosis processor during the fault diagnosis period and outputs the signals output from the plurality of scan chains to the outside of the SoC during the fault non-diagnosis period,
wherein the group of fourth switches is provided in correspondence with the plurality of scan chains, respectively.

32. The SoC (110) as claimed in claim 31, wherein the first switch (703_1) comprises a multiplexer, the second switch (703_2) comprises a multiplexer, the third switch (703_3) comprises a multiplexer, and the group of fourth switches (704_l, 704_n) comprises a group of demultiplexers.

33. The SoC (110) as claimed in claim 26, further comprising:
a first switch (703_l) which sends the pseudo random pattern to the plurality of scan chains (113_l, 113_n) during the fault diagnosis period and transmits a scan input signal input from an outside of the SoC to the plurality of scan chains during a fault non-diagnosis period, under the control of the diagnosis processor (111,701);
a second switch (703_2) which sends a diagnosis scan enable signal output from the diagnosis processor to the plurality of scan chains during the fault diagnosis period and transmits a scan enable signal input from the outside of the SoC to the plurality of scan chains during the fault non-diagnosis period, under the control of the diagnosis processor; and
a group of third switches (704_l, 704_n) which transmits signals output from the plurality of scan chains to the diagnosis processor during the fault diagnosis period and outputs the signals output from the plurality of scan chains to the outside of the SoC during the fault non-diagnosis period,
wherein the group of third switches is provided in correspondence with the plurality of scan chains, respectively.

34. The SoC (110) as claimed in claim 33, wherein the first switch (703_1) comprises a multiplexer, the second switch (703_2) comprises a multiplexer, and the group of third switches comprises a group of demultiplexers.

35. A computer readable medium encoded with the method of claim 23 implemented by a computer.

36. An electronics product comprising:
a system-on-chip (SoC) (110), mounted inside the product, that receives a fault diagnosis request instruction, diagnoses its own faults, and outputs a diagnosis result; and
a fault diagnosis apparatus that inputs the fault diagnosis request instruction to the SoC, and outputs the diagnosis result to an outside of the product.

37. The product as claimed in claim 36, wherein the fault diagnosis apparatus comprises:
an instruction input unit (106) which inputs the fault diagnosis request instruction to the SoC; and
an output unit (120) which receives the diagnosis result from the SoC and outputs the diagnosis result to the outside of the product.

38. The product as claimed in claim 36 or 37, wherein the fault diagnosis apparatus comprises:
a transmission/reception unit (301) which receives the fault diagnosis request instruction of the SoC (110) through a network, sends the fault diagnosis request instruction to the SoC, receives the diagnosis result from the SoC, and transmits the diagnosis result to the network.

39. The fault diagnosis apparatus as claimed in any one of claims 36 - 38, wherein the SoC (110) comprises:
a plurality of scan chains (113_l, 113_n) which outputs values of results of a pseudo random pattern input therein;
a pseudo random pattern generator (112) which generates the pseudo random pattern to be applied to the plurality of scan chains in the SoC during a fault diagnosis period; and
a diagnosis processor (111, 502,701) which receives the fault diagnosis request instruction, enables the pseudo random pattern generator, monitors the values output from the plurality of scan chains, diagnoses faults in the plurality of scan chains, and outputs the diagnosis result.

40. The fault diagnosis apparatus as claimed in claim 39, wherein the SoC (110)further comprises a built-in-self-test (BIST) logic circuit (501),
wherein the diagnosis processor (111, 502, 701) receives the fault diagnosis request instruction, provides a control signal to the BIST logic circuit, diagnoses faults in the BIST logic circuit based on a test result signal provided from the BIST logic circuit, and outputs the diagnosis result.
